# EUROPEAN PATENT APPLICATION

(11) **EP 0 661 915 A1**
(43) Date of publication of application: **05.07.1995**
(21) Application number: 94120797.9
(22) Date of filing: 28.12.1994
(51) Int. Cl.: H05K 7/14

(54) **Modular control device**

(30) Priority: 28.12.1993 JP 351519/93
(71) Applicant: RKC Instruments Inc., Tokyo, 146 (JP)
(72) Inventor: Yoshino, Tooru, Yokohama-shi, Kanagawa-ken, 233 (JP); Kobayashi, Denzaburo, Ohta-ku, Tokyo, 146 (JP); Ishiwata, Akihiro, Kawasaki-shi, Kanagawa-ken, 210 (JP)
(74) Representative: Blumbach, Kramer & Partner

(57) **Abstract**

In a modular control device consisting of a combination of a plurality of control modules, interchangeability of the components is increased. The manufacturer is required to produce fewer kinds of components and can therefore benefit from the reduced cost in manufacturing and maintaining a stock. The user can benefit from the facility and the reduction in cost in expanding and otherwise modifying the control device. A base member including a base circuit is individually and detachably mounted on a rail, and is adapted to be electrically and mechanically connected to adjacent base members. The main circuit board for each control module can be detachably mounted on any base member. Thus, a new control module can be added simply by adding a base member in addition to the new control module. An existing control module may be replaced with a new one simply by removing the existing control module from the base member and mounting the new control module on the same base member. A larger control module can be accommodated by assigning a plurality of base members for the large control module.

## Description

### TECHNICAL FIELD

The present invention relates to control devices, and in particular to an improvement of individual control modules which can form programmable controllers, system controller and other control devices by combining a plurality thereof.

### BACKGROUND OF THE INVENTION

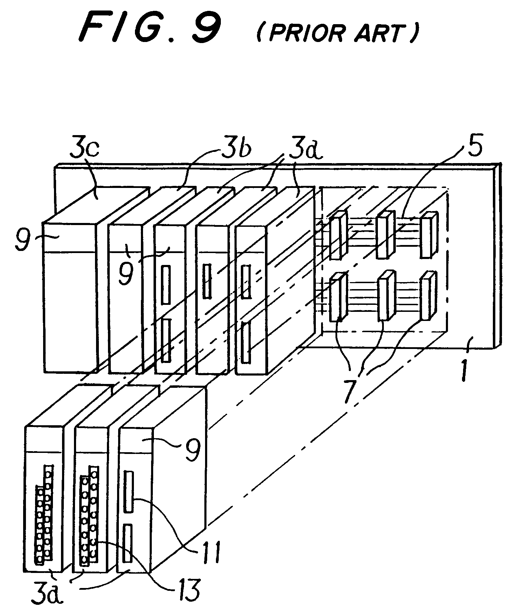

As a control device such as a programmable controller for computer controlling a production line or the like, there is known the structure illustrated in Figure 9 in which a plurality of box-shaped control modules 3a, 3b and 3c are clustered into a group and are jointly mounted on a common support base plate 1.

These control modules 3a to 3c individually incorporate therein various electronic circuits not shown in the drawing, and serve as an input/output module 3a for input/output control or communication control of digital or analog signals, a main control module 3b including a CPU unit or the like for carrying out arithmetic processes, and a power source module 3c for converting AC utility power into a stabilized DC power, and supplying it to other control modules.

These control modules 3a to 3c are detachably mounted on a plurality of support connectors 7 which are in turn securely attached to the support base plate 1 and mutually connected by a composite signal line 5, and jointly form a control device such as a programmable controller.

The front face of each of the control modules 3a to 3c is provided with a display unit 9 which lights up according to the operating condition of the corresponding control module, and the front faces of the input/output modules 3a are provided with connectors 11 and terminal bases 13 for connection with external equipment not shown in the drawing.

The manufacturer of these control modules 3a to 3c normally prepare a number of different support base plates 1 having different arrangement of support connectors 7, and the buyer can choose a support base plate 1 corresponding to the number of control modules that suits the intended size of the system such as the programmable controller and the need of the buyer to expand or modify the size of the system.

However, when a system such as a programmable controller is desired to be constructed by using the control modules 3a to 3c described above, one would encounter the following problems that need to be resolved.

Specifically, the manufacturer needs to prepare a number of different support base plates 1 having different numbers of support connectors 7 in advance to meet every possible need of the user, and this involves substantial cost and effort in manufacturing and stocking.

On the part of the user, although a number of different support base plates 1 may be available, there is a limit in the number of control modules 3a to 3c each support base plate 1 can carry, and he has to purchase an additional support base plate 1 if he wishes to expand or otherwise modify the system. Thus, the conventional arrangement is not flexible enough to readily adapt itself to modification, and tends to require a high cost when a modification is effected.

### BRIEF SUMMARY OF THE INVENTION

In view of such problems of the prior art, a primary object of the present invention is to provide a modular control device which can adapt itself to any size or complexity of the system, and allow its control modules to be readily changed without requiring any new support base plate having a different arrangement of connecting means such as support connectors.

A second object of the present invention is to provide a modular control device which is so adaptable that the manufacturer is not required to produce a large number of different support base plates and stock all of them.

A third object of the present invention is to provide a modular control device which is so adaptable that the user can modify an existing control device with a minimum cost.

A fourth object of the present invention is to provide a modular control device which allows its control modules to be replaced both quickly and simply.

A fifth object of the present invention is to provide a modular control device which can easily accommodate large control modules without requiring any special adapters.

These and other objects of the present invention can be accomplished by providing a control device, comprising: a base member including a base circuit; base connectors arranged on the base member in association with the base circuit and directed to either lateral side thereof; and a module connector formed on the base member and electrically connected to the base circuit; a control module adapted to be mounted on the base member, and provided with a module circuit board adapted to be connected to the module connector; the base connectors being each adapted to be connected to an associated connector provided on an opposing lateral side of an adjacent base member.

The base members may be individually and detachably mounted on a common mount such as a rail, and are adapted to be electrically and mechanically connected to adjacent base members. The module circuit board for each control module can be detachably mounted on any base member. Thus, a new control module can be added simply by adding a base member in addition to the new control module. An existing control module may be replaced with a new one simply by removing the existing control module from the base member and mounting the new control module on the same base member. Thus, the manufacturer is required to produce fewer kinds of components and can therefore benefit from the reduced cost in manufacturing and maintaining a stock. The user can benefit from the facility and the reduction in cost in expanding and otherwise modifying the control device. According to a certain aspect of the present invention, the casing is adapted to be detached from the base member without disconnecting the module circuit board from the module connector.

If the base circuit and the base connectors are mounted on a base circuit board which is detachably mounted on a base member main body, it is possible to standardize the base member main body, and modify the base circuit and/or connectors without increasing the cost in manufacturing and stocking the base members.

In particular, if the base connectors comprise connecting pins projecting from one lateral side of the base member, and connecting sockets for receiving connecting pins projecting laterally from an adjacent base member, a plurality of base members can be readily joined with one another simply by fitting the connecting pins into the associated connecting sockets.

According to a preferred embodiment of the present invention, the control module comprises a casing which can be mounted on the base member and removably receive the module circuit board therein, and the casing is provided with notches for exposing the base connectors so that the provision of the casing would not interfere with the base connectors. Also, a larger control module can be accommodated by assigning a plurality of base members for the large control module.

### BRIEF DESCRIPTION OF THE DRAWINGS

Now the present invention is described in the following with reference to the appended drawings, in which:
Figure 1 is an exploded fragmentary perspective view of an embodiment of the control device according to the present invention;
Figure 2 is a front view of one of the module circuit boards mounted on the associated base member with the casing and the module circuit board omitted for better clarity;
Figure 3 is a sectional view taken along line III-III of Figure 2;
Figure 4 is a front view similar to Figure 2 showing a pair of adjacent base members joined together;
Figure 5 is a sectional view taken along line V-V of Figure 4;
Figure 6 is a sectional view similar to Figure 5 with the casing fitted onto the base member;
Figure 7 is a perspective view showing the module circuit board and the casing;
Figure 8 is a perspective view showing an example of application of the control device according to the present invention; and
Figure 9 is a perspective view showing a conventional control device.

### DETAILED DESCRIPTION OF THE PREFERRED EMBODIMENTS

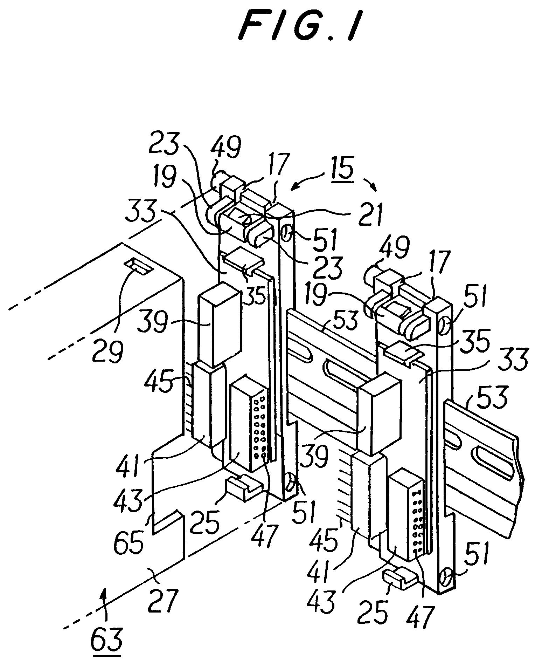

Figure 1 is an exploded perspective view of an essential part of an embodiment of the control device according to the present invention. This control device is constructed by combining a number of control modules which can carry out similar or different functions. However, each control module has certain standardized common features as described hereinafter, and the following description is in some places directed only to a single individual control module for the convenience of description.

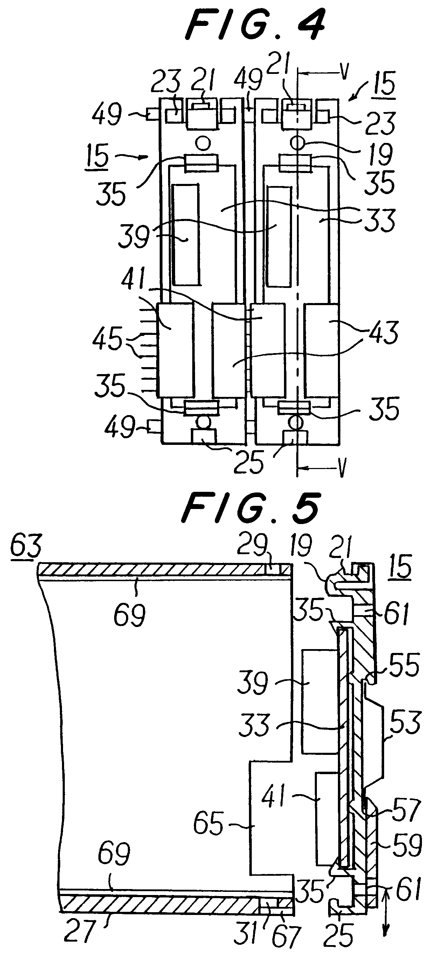

Referring to Figure 1, an electrically insulating base member 15 consists of an elongated planar member, and a U-shaped engagement piece 19 projects from an upper part of the vertically placed base member located between a pair of slots 17 cut into the base member 15 from its upper edge (refer to Figure 5). An engagement projection 21 projects from the engagement piece 19, and a pair of support pieces 23 extend along either side of the engagement piece 19 and the slots 17.

An engagement piece 25 projects from a lower end portion of the base member 15, and the free end of this engagement piece 25 slightly projects upward into the shape of letter-L. The support pieces 23 and the engagement piece 25 can slide along the inner surfaces of a casing 27, and can fit into associated engagement holes 29 and 31 (31 is hidden in Figure 1) of the casing 27.

An elongated base circuit board 33 is placed between the engagement pieces 19 and 25, and extends along the front surface of the base member 15, and is kept slightly spaced from the base member 15 by a pair of engagement columns 35 and 35 (the lower column is hidden in Figure 1).

This base circuit board 33 carries a module connector 39 adapted to be connected to a module circuit board 37 received in the casing 27 as described hereinafter, and first and second base connectors 41 and 43 adapted to be electrically connected to the associated base connectors of the adjacent base members 15. These connectors 39 to 43 are electrically connected with one another via the base circuit board 33, and the first and second base connectors 41 and 43 form a part of a composite signal line 5 similar to the conventional composite signal line mentioned earlier.

In particular, the first base connector 41 is placed on the vertically placed support member 15 via the base circuit board 33 in such a manner that the first base connector 41 is located on one lateral side of the base member 15, and the connecting pins 45 of the first base connector 41 project from the corresponding long side of the base member 15. The second base connector 43 is located on the other lateral side of the base member 15, and is provided with connecting sockets 47 adapted to receive the connecting pins 45 of the first base connector 41 of the adjacent base member 15.

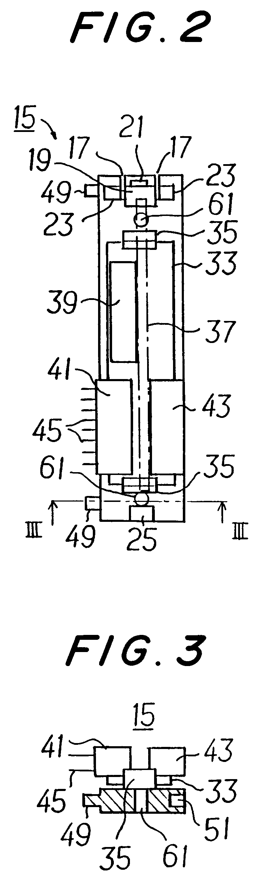

As shown in Figures 1 to 3, each of the base members 15 is integrally provided with a pair of engagement projections 49 projecting from upper and lower ends of one of the long sides of the base member 15 from which the connecting pins 45 project, and upper and lower ends of the opposing long side of the adjacent base member 15 are provided with engagement holes 51 adapted to receive the corresponding engagement projections 49 of the adjacent base member 15. Figure 3 shows only the lower engagement projection 49 and the lower engagement hole 51 of the base members 15, but the upper engagement projection 49 and the upper engagement hole 51 are also provided with similar structures.

Thus, the base members 15 can be mechanically and firmly joined to one another by fitting the connecting pins 45 of the first base connector 41 of one of the base members 15 into the second base connector 43 of the adjacent base member 15, and engaging the engagement projections 49 with the associated engagement holes 51. At the same time, the composite signal line 5 can be sequentially extended by the first and second base connectors 41 and 43.

To further strengthen the attachment between the base members 15, in addition to the engagement structure consisting of the engagement projections 49 and the engagement holes 51, it is also possible to secure the engagement projections 49 in the associated engagement holes 51 by using threaded bolts. For instance, the holes 51 may be completely passed through across the base member 15, and long threaded bolts may be passed coaxially through these holes 51. It is also possible to use latches which may be engaged by the slots 17 to prevent inadvertent detachment of the base members 15 although it is not shown in the drawings.

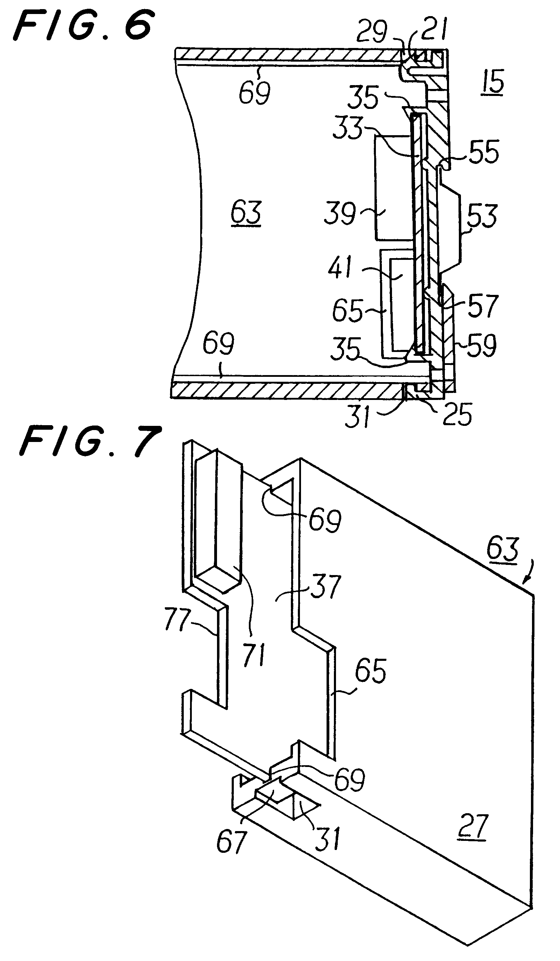

The base member 15 is provided with upper and lower engagement grooves 55 and 57 (refer to Figures 5 and 6) on a rear surface thereof adapted to engage a DIN rail 53 or the like, and can be adapted for easy attachment and detachment to and from the rail 53, for instance, by pulling a slide piece 59 downward against a biasing force. The slide piece 59 is vertically slidably supported and is urged upward by suitable spring means.

In Figures 2 to 5, numeral 61 denotes threaded holes for attaching the base member 15 to a support plate mounted on a wall which is not shown in the drawings.

The casing 27 of the control module 63 fitted onto the base member 15 is made of plastic material molded into the shape of a box, and, as shown in Figures 5 to 7, is provided with an opening conforming to the outer profile of the base member 15, and a pair of notches 65 cut into the edges of either side of the opening in the shape of letter C in such a manner that the first and second base connectors 41 and 43 would not interfere with the casing 27 when it is fitted onto the base member 15, and appropriately expose the first and second base connectors 41 and 43. The material of the casing 27 is not limited to synthetic resin material, and may consist of other materials such as metal as long as it can be formed into the necessary shape.

An engagement hole 29 is provided on a part of the upper surface of the casing 27 adjacent to the opening for engaging the engagement projection 21 of the engagement piece 19 of the base member 15, and an engagement hole 31 (refer to Figures 5 to 7) is provided in a part of the lower surface of the casing 27 adjacent to the opening in addition to a slide groove 67 for slidably receiving a free end of the engagement piece 25.

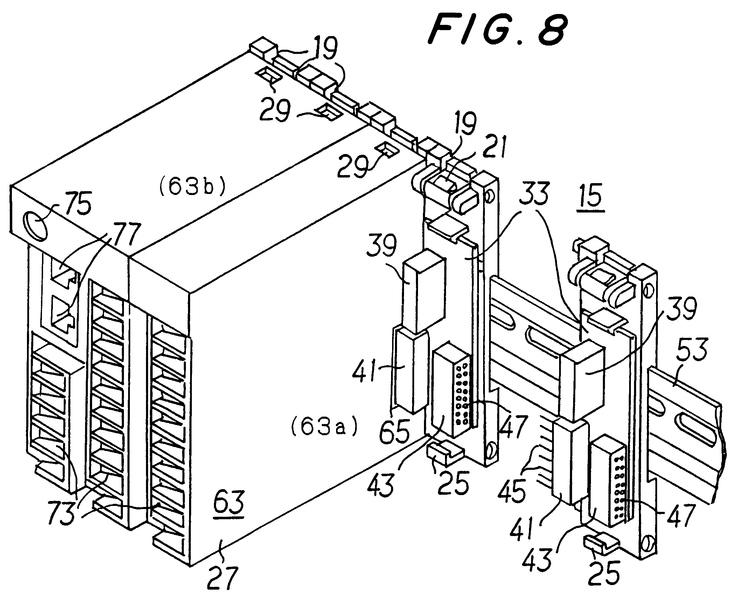

The casing 27 accommodates therein a module circuit board 37 fitted therein through insertion grooves 69 extending from the opening, and a connector 71 is mounted on this module circuit board 37. This module circuit board 37 carries an electronic circuit for carrying out, for instance, the functions of an input/output unit 63a and a main control device 63b as shown in Figure 8.

The module circuit board 37 is received in the casing 27 in such a manner that the module circuit board 37 occupies its position between the first and second base connectors 41 and 43 as indicated by one-dot chain lines of Figure 2, and comes into contact with connecting pieces of a terminal members (not shown in the drawings) extending from a terminal base 73 (refer to Figure 8) placed on the front face of the casing 27 as described hereinafter into the interior of the casing 27.

If the module circuit board 37 is provided with a notch 77 as illustrated in Figure 7, it can be placed over the first and second base connectors 41 and 43 without interfering with them.

The connector 71 is provided on one side of the module circuit board 37, and is provided with such a shape and placed at such a position that it will be connected to the module connector 39 when the casing 27 is fitted onto the base member 15.

Therefore, when the interior of the casing 27 is aligned with the engagement piece 19 and the support pieces 23 of the base member 15 with the engagement piece 25 fitted into the slide groove 67, and the connector 71 is aligned with the module connector 39, pushing the casing 27 onto the base member 15 will cause the engagement projection 21 of the base member 15 to be fitted into the engagement hole 29, the free end of the engagement piece 25 to be engaged by the engagement hole 31, and the control module 63 to be secured onto the base member 15, as illustrated in Figures 5 and 6. Furthermore, the module circuit board 37 is connected to the module connector 39 which is in turn connected to the circuit of the base circuit board 33. The circuit of the base circuit board 33 is connected to the adjacent base circuit boards 33 via the first and second base connectors 41 and 43.

When the engagement projection 21 is disengaged from the engagement hole 29 by pushing down the engagement piece 19 of the base member 15, the casing 27 can be removed from the base member 15.

According to the present invention, the structures formed between the engagement piece 19 and the engagement hole 29 and between the engagement piece 25 and the engagement hole 31 can be provided in both upper and lower parts, and their relationships can be reversed.

The structure of the casing 27 of the control module 63 adapted to be mounted on the base member 15 can be freely determined. For instance, the front face may be provided with a terminal base 73 for external connection, an access hole 75 for operating an internal rotary switch, and connector holes 77 for communication purpose, as shown in Figure 8.

The operation of the above described control device according to the present invention is now briefly described in the following.

In use, for instance as shown in Figure 8, four base members 15 are mounted on the rail 53, and the first and second base connectors 41 and 43 of a pair of adjacent base members 15 are connected to each other, and is thus mutually secured. The control modules 63 (input/output modules 63a, main control modules 63b, and power source modules) are mounted on these base members 15.

When another control module 63 is required to be installed, the system can be expanded by mounting an additional identical base member 15 on the rail 53, and fitting an additional control module 63 onto this additional base member 15. If desired, it is possible to modify the system by replacing the control module 63 with another using the same base member 15.

The control device of the present invention is provided with a structure which may be summarized as given in the following. A module connector 39, and first and second base connectors 41 and 43 are mounted on a printed circuit board 33 which is in turn supported by a base member 15, and are arranged in such a manner that the connecting pins 45 of the first base connector 41 can be connected to the second base connector 43 of the adjacent base member 15. Engagement pieces 19 and 25 are provided on upper and lower ends of the base member 15, and the control module 63 incorporated with the module circuit board 37 is installed by engaging it with the engagement pieces 19 and 25, and the connector 71 of the module circuit board 37 is connected to the module connector 39. Therefore, the base member 15 can be used as a common component for different types of control modules 63, and clustering and separating the base members 15 are simplified. Furthermore, a desired control module 63 can be mounted on any one of the base members 15 at will.

Therefore, the manufacturer is not required to stock a number of different types of support base plates 1 for various possible needs of the user.

As for the user, because standardized common base members 15 can be connected into a desired number of stages, and can be separated at will, the number of the control modules 63 that can be incorporated into the system is not limited, and the expansion and modification of the system can be accomplished in a simple manner.

Furthermore, because the base member 15 is provided with a first base connector 41 having connecting pins 45 projecting therefrom, and a second base connector 43 having connecting sockets 47 for receiving the connecting pins 45 of the first base connector 41, a plurality of base members 15 can be electrically connected with one another simply by fitting the connecting pins 45 of the first base connector 41 into the associated connecting sockets 47 of the second base connector 43 of the adjacent base member 15. The separation of the base members 15 can be equally readily effected simply by pulling the connecting pins 45 from the connecting sockets 47.

Furthermore, because the module circuit board 37 of the control module 63 is fitted into the casing 27 guided by insertion grooves 69 provided in the casing 27, and the connector 71 is connected to the module circuit board connector 39 of the base member 15, not only the base member 27 but also the casing 27 is adapted to be removed in a simple manner, and maintenance of the module circuit board 37 is simplified.

Also, because the casing 27 of the control module 63 is provided with notches 65 on either side thereof, the first and second base connectors 41 and 43 are exposed from the side faces, and the connection and separation of the base member 15 can be accomplished in a simple manner.

According to the control device of the present invention, it is possible to handle two or more of base members 15 as an individual base member when a control module 63 incorporated with a plurality of module circuit boards and assigned with a large number of functions is required to be installed, when a large number of input/output terminals are required to be provided on a single control module, or when the control module is commonly used by a number of different parts of the control system.

For instance, in the case of the control module 63 (main control module 63b) illustrated in Figure 8, it is possible to fit a casing 27 onto a double slot type base member 15 formed by combining two basic base members 15, and, alternatively, it is also possible to remove the individual circuit boards 33 of the connected base members 15, and replace it with a circuit of a double width although it is not shown in the drawings.

According to this structure, it is possible to group together a combination of control modules 63 which are often used in combination as a part of an overall structure of a control system, for instance a combination of a power source module and a CPU unit (a main control device). By doing so, it is possible to eliminate the first and second connectors, and this contributes to the reduction of cost.

In the above described embodiment, the first and second base connectors 41 and 43 are not necessarily required to be individually provided as long as the module circuit board connector 39 is electrically connected to the base connectors 41 and 43 via the base member 15 or the circuit board 33, and the base connectors 41 and 43 in turn connect the circuit boards 33 of adjacent base members 15 with each other. Also, the connecting pins 45 of the base connectors 41 are not necessarily required to project laterally from the base member 15 as long as the base connectors 41 and 43 of adjacent circuit boards 33 can be connected with each other. The structure of the connectors themselves can be also freely determined.

In the above described embodiment, it is not essential to arrange the circuit board 33 on the base member 15, and the circuit board 33 can be eliminated by appropriately arranging and connecting the module base connector 39 and the base connectors 41 and 43.

In the above described embodiment of the present invention, the control modules were arranged laterally, but may also be arranged vertically or one over the other.

According to the control device of the present invention described above, adjacent base members can be separably connected to each other via base connectors, and the base members can be standardized for various kinds of control modules. Thus, a number of control modules can be joined and separated at will, and the internal module circuit board of each control module can be detachably mounted on the base member.

Therefore, the manufacturer benefits from the improved handling of the control modules and base members, and the simplified stock management, and the user benefits from the possibility of readily combining and separating standardized common base members, the facility of expansion and modification of the system, and the resulting reduction in cost.

Additionally, by providing projecting connecting pins and the associated connecting sockets in the base connectors, connection and separation of a plurality of base members is further facilitated.

By forming the control module with a module circuit board detachably fitted in the casing, maintenance work is simplified without impairing the facility in detaching the module circuit board which has been an advantage of the conventional support base plate structure.

According to the structure in which notches are formed in the control module, because the base members can be connected to each other irrespective of whether the control module is mounted on the base member or not, connecting the base members is even more simplified.

According to the structure in which a single casing is mounted on a plurality of mutually connected base members, the base members can be used without modification even when the size of the control module is increased. Thus, the base members can be standardized without regard to the size of the control module.

Although the present invention has been described in terms of a preferred embodiment thereof, it is obvious to a person skilled in the art that various alterations and modifications are possible without departing from the scope of the present invention which is set forth in the appended claims.

## Claims

1. A control device, comprising:
a base member including a base circuit;
base connectors arranged on said base member in association with said base circuit and directed to either lateral side thereof; and
a module connector formed on said base member and electrically connected to said base circuit; and
a control module adapted to be mounted on said base member, and provided with a module circuit board adapted to be connected to said module connector;
said base connectors being each adapted to be connected to an associated connector provided on an opposing lateral side of an adjacent base member.

2. A control device according to claim 1, wherein said casing is adapted to be detached from said base member without disconnecting said module circuit board from said module connector.

3. A control device according to claim 1, wherein said base circuit and said base connectors are mounted on a base circuit board which is detachably mounted on a base member main body.

4. A control device according to claim 1, wherein said base connectors comprise connecting pins projecting from one lateral side of said base member, and connecting sockets for receiving connecting pins projecting laterally from an adjacent base member.

5. A control device according to claim 4, wherein said control module comprises a casing which can be mounted on said base member and removably receive said module circuit board therein.

6. A control device according to claim 5, wherein said casing is provided with notches for exposing said base connectors.

7. A control device according to claim 1, wherein said base member is provided with a lateral slot on a reverse surface thereof for mounting said base member on a lateral rail.

8. A control device according to claim 1, wherein said control module comprises a single casing which is adapted to be mounted on a plurality of mutually joined base members.
